(19) Europäisches Patentamt
European Patent Office
Office européen des brevets

(11) **EP 2 287 657 A1**

(12) **EUROPEAN PATENT APPLICATION**
published in accordance with Art. 153(4) EPC

(43) Date of publication:
**23.02.2011 Bulletin 2011/08**

(51) Int Cl.:
**G02F 1/133** *(2006.01)*     **G02F 1/1335** *(2006.01)*
**G02F 1/1368** *(2006.01)*     **G09F 9/30** *(2006.01)*
**H01L 31/10** *(2006.01)*

(21) Application number: **09758259.7**

(22) Date of filing: **28.05.2009**

(86) International application number:
**PCT/JP2009/059769**

(87) International publication number:
**WO 2009/147992 (10.12.2009 Gazette 2009/50)**

(84) Designated Contracting States:
**AT BE BG CH CY CZ DE DK EE ES FI FR GB GR HR HU IE IS IT LI LT LU LV MC MK MT NL NO PL PT RO SE SI SK TR**
Designated Extension States:
**AL BA RS**

(30) Priority: **03.06.2008   JP 2008146072**

(71) Applicant: **Sharp Kabushiki Kaisha Osaka-shi, Osaka 545-8522 (JP)**

(72) Inventors:
• **KATOH, Hiormi**
**Osaka-shi**
**Osaka 545-8522 (JP)**
• **Brown, Christopher**
**Oxford**
**OX4 4GB**
**United Kingdom (JP)**

(74) Representative: **Goddar, Heinz J. et al**
**Forrester & Boehmert**
**Pettenkoferstrasse 20-22**
**80336 München (DE)**

(54) **DISPLAY DEVICE**

(57)     Provided is a display device with a photosensor having little variation between sensors. The display device includes a photosensor in a pixel region of an active matrix substrate. The photosensor includes a photodetection element (M4) that receives incident light, a capacitor (C1), one electrode of which is connected to the photodetection element (M4), that accumulates output current from the photodetection element, reset signal wiring (RST) that supplies a reset signal to the photosensor, readout signal wiring (RWS) that supplies a readout signal to the photosensor, and a sensor switching element (M2) that, in accordance with the readout signal, reads out the output current accumulated in the capacitor (C1) from when the reset signal is supplied until when the readout signal is supplied. A phototransistor is used as the photodetection element (M4).

Fig. 2

EP 2 287 657 A1

**Description**

Technical Field

The present invention relates to a display device with a photosensor having a photodetection element such as a photodiode or phototransistor, and in particular to a display device that includes a photosensor inside a pixel region.

Background Art

Conventionally, there has been proposed a display device with a photosensor that, due to including a photodetection element such as a photodiode inside a pixel, can detect the brightness of external light and pick up an image of an object that has come close to the display Such a display device with a photosensor is envisioned to be used as a bidirectional communication display device or display device with a touch panel function.

With a conventional display device with a photosensor, when using a semiconductor process to form known constituent elements such as signal lines, scan lines, TFTs (Thin Film Transistor), and pixel electrodes on an active matrix substrate, a photodiode or the like is simultaneously formed on the active matrix substrate (see PTL 1 and NPL 1).

FIG. 12 shows an example of a conventional photosensor (PTL 2 and 3) formed on an active matrix substrate. The conventional photosensor shown in FIG. 12 is configured by a photodiode D1, a capacitor C2, and a transistor M2. The anode of the photodiode D1 is connected to wiring RST, which is for supplying a reset signal. The cathode of the photodiode D1 is connected to one electrode of a capacitor C2 and the gate of the transistor M2. The drain of the transistor M2 is connected to wiring VDD, and the source is connected to wiring OUT. The other electrode of the capacitor C2 is connected to wiring RWS, which is for supplying a readout signal.

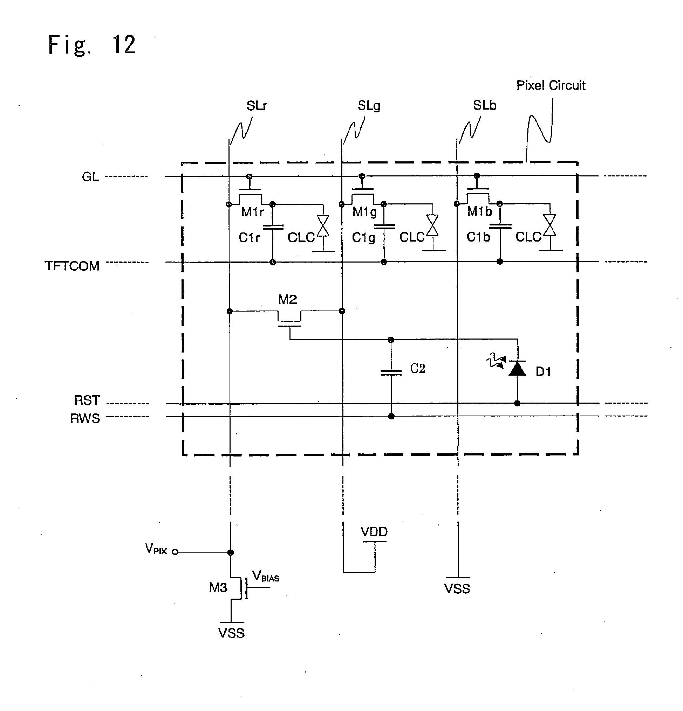

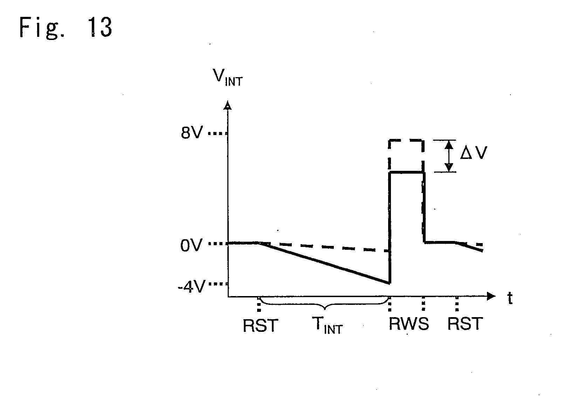

In this configuration, the reset signal and the readout signal are respectively supplied to the wiring RST and the wiring RWS at predetermined times, thus enabling obtaining sensor output $V_{PIX}$ that is in accordance with the amount of light received by the photodiode D1. A description is now given of operations of the conventional photosensor shown in FIG. 12, with reference to FIG. 13. Note that the reset signal at low level (e.g., -4 V) is shown as $V_{RST.L}$, the reset signal at high level (e.g., 0 V) is shown as $V_{RST.H}$, the readout signal at low level (e.g., 0 V) is shown as $V_{RWS.L}$, and the readout signal at high level (e.g., 8 V) is shown as $V_{RWS.H}$.

First, when the high level reset signal $V_{RST.H}$ is supplied to the wiring RST (time t=RST in FIG. 12), the photodiode D1 becomes forward biased, and a potential $V_{INT}$ of the gate of the transistor M2 is expressed by Expression (1) below.

$$V_{INT} = V_{RST.H} - V_F \qquad ...(1)$$

In Expression (1), $V_F$ is the forward voltage of the photodiode D1, $\Delta V_{RST}$ is the height of the reset signal pulse ($V_{RST.H}$ - $V_{RST.L}$), and $C_{PD}$ is the capacitance of the photodiode D1. $C_T$ is the sum of the capacitance of the capacitor C2, the capacitance $C_{PD}$ of the photodiode D1, and a capacitance $C_{TFT}$ of the transistor M2. Since $V_{INT}$ is lower than the threshold voltage of the transistor M2 at this time, the transistor M2 is in a non-conducting state in the reset period.

Next, the reset signal returns to the low level $V_{RST.L}$, and thus the photocurrent integration period (period $T_{INT}$ shown in FIG. 13) begins. In the integration period, a photocurrent that is proportionate to the amount of incident light received by the photodiode D1 flows to the capacitor C2, and causes the capacitor C2 to discharge. Accordingly, the potential $V_{INT}$ of the gate of the transistor M2 when the integration period ends is expressed by Expression (2) below.

$$V_{INT} = V_{RST.H} - V_F - \Delta V_{RST} \cdot C_{PD}/C_T - I_{PHOTO} \cdot T_{INT}/C_T \qquad ...(2)$$

In Expression (2), $I_{PHOTO}$ is the photocurrent of the photodiode D1, and $T_{INT}$ is the length of the integration period. In the integration period as well, $V_{INT}$ is lower than the threshold voltage of the transistor M2, and therefore the transistor M2 is in the non-conducting state.

When the integration period ends, the readout signal RWS rises at a time t=RWS shown in FIG. 13, and thus the readout period begins. Note that the readout period continues while the readout signal RWS is at high level. Here, the injection of charge into the capacitor C2 occurs. As a result, the potential $V_{INT}$ of the gate of the transistor M2 is expressed by Expression (3) below.

$$V_{INT} = V_{RST.H} - V_F - \Delta V_{RST} \cdot C_{PD}/C_T - I_{PHOTO} \cdot T_{INT}/C_T$$

$$+\Delta V_{RWS} \cdot C_{INT}/C_T \qquad ...(3)$$

$\Delta V_{RWS}$ is the height of the readout signal pulse ($V_{RWS.H}$ - $V_{RWS.L}$). Accordingly, since the potential $V_{INT}$ of the gate of the transistor M2 becomes higher than the threshold voltage, the transistor M2 enters the conducting state and functions as a source follower amplifier along with a bias transistor M3 provided at the end of the wiring OUT in each column. In other words, a sensor output voltage $V_{PIX}$ from the transistor M2 is proportionate to the integral value of the photocurrent of the photodiode D1 in the integration period.

Note that in FIG. 13, the broken line waveform indicates change in the potential $V_{INT}$ in the case where a small amount of light is incident on the photodiode D 1, and the solid line waveform indicates change in the potential $V_{INT}$ in the case where external light has incidented on the photodiode D1. In FIG.13, $\Delta V$ is a potential difference proportionate to the amount of light that has incidented on the photodiode D1.

Citation List

Patent Literature

PTL 1: JP 2006-3857A
PTL 2: WO 2007/145346
PTL 3: WO 2007/145347

Non Patent Literature

NPL 1: "A Touch Panel Function Integrated LCD Including LTPS A/D Converter", T. Nakamura et al., SID 05 DIGEST, pp.1,054-1,055, 2005

Disclosure of Invention

Problem to be Solved by the Invention

Note that the photodiode used as the photodetection element in the conventional photosensor described above requires two processes for respectively forming a p channel region (P+) and an n channel region (n+). Specifically, the width of the i layer, which is an important parameter that influences the characteristics of the photodiode, is determined in the two layer forming steps for forming the n layer and the p layer. For this reason, the width of the i layer is doubly influenced by shift variation in the photolithography step when forming the n layer and the p layer.

The present invention has been achieved in light of the above-described issues, and an object of the present invention is to provide a display device with a photosensor that has little variation between sensors due to using, as a photodetection element, a phototransistor that has little variation in characteristics in the photolithography step.

Means for Solving Problem

In order to address the above-described issues, a display device according to the present invention is a display device including a photosensor in a pixel region of an active matrix substrate, the photosensor including: a photodetection element that receives incident light; a capacitor, one electrode of which is connected to the photodetection element, that accumulates output current from the photodetection element; reset signal wiring that supplies a reset signal to the photosensor; readout signal wiring that supplies a readout signal to the photosensor; and a sensor switching element that, in accordance with the readout signal, reads out the output current accumulated in the capacitor from when the reset signal is supplied until when the readout signal is supplied, wherein the photodetection element is a phototransistor.

Effects of the Invention

The present invention enables providing a display device with a photosensor that has little variation between sensors due to using, as a photodetection element, a phototransistor that has little variation in characteristics in the photolithography step.

Brief Description of Drawings

[FIG. 1] FIG. 1 is a block diagram showing a schematic configuration of a display device according to an embodiment of the present invention.
[FIG. 2] FIG. 2 is an equivalent circuit diagram showing a configuration of a pixel in a display device according to Embodiment 1 of the present invention.
[FIG. 3] FIG. 3 is a timing chart for input signals (RST and RWS) in a photosensor according to Embodiment 1.
[FIG. 4] FIG. 4 is a waveform diagram showing a relationship between input signals (RST and RWS) and $V_{INT}$ in the photosensor according to Embodiment 1.
[FIG. 5] FIG. 5 is a timing chart showing sensor drive timing in the display device according to Embodiment 1.
[FIG. 6] FIG. 6 is a circuit diagram showing an internal configuration of a sensor pixel readout circuit.
[FIG. 7] FIG. 7 is a waveform diagram showing a relationship between a readout signal, sensor output, and output of the sensor pixel readout circuit.
[FIG. 8] FIG. 8 is a circuit diagram showing an exemplary configuration of a sensor column amplifier.
[FIG. 9] FIG. 9 is an equivalent circuit diagram showing a configuration of a pixel in a display device according to Embodiment 2 of the present invention.
[FIG. 10] FIG. 10 is a waveform diagram showing a relationship between input signals (RST and RWS) and $V_{INT}$ in the photosensor according to Embodiment 1.
[FIG. 11] FIG.11 is a waveform diagram showing, as a comparative example, change in $V_{INT}$ in the case where the drop in the potential of the reset signal RST was not steep in the configuration according to Embodiment 1.
[FIG. 12] FIG. 12 is an equivalent circuit diagram showing an exemplary configuration of a conventional photosensor.
[FIG. 13] FIG. 13 is a waveform diagram showing $V_{INT}$ in the case where the reset signal RST and the readout signal RWS have been applied to the conventional photosensor.

Description of the Invention

Embodiment 1

A display device according to an embodiment of the present invention is a display device including a photosensor in a pixel region of an active matrix substrate, the photosensor including: a photodetection element that receives incident light; a capacitor, one electrode of which is connected to the photodetection element, that accumulates output current from the photodetection element; reset signal wiring that supplies a reset signal to the photosensor; readout signal wiring that supplies a readout signal to the photosensor; and a sensor switching element that, in accordance with the readout signal, reads out the output current accumulated in the capacitor from when the reset signal is supplied until when the readout signal is supplied, wherein the photodetection element is a phototransistor.
In the above-described display device, the phototransistor can be realized by an amorphous silicon TFT or a microcrystalline silicon TFT. Also, in the above-described display device, the sensor switching element can be configured by an amorphous silicon TFT or a microcrystalline silicon TFT. Forming the phototransistor and/or the sensor switching element from an amorphous silicon TFT or a microcrystalline silicon TFT in this way enables inexpensively providing a display device with a photosensor.
Also, a configuration is possible in which a gate and a source of the phototransistor are connected to the reset signal wiring. Alternatively, a configuration is possible in which the gate is connected to the reset signal wiring, and the source is connected to second reset signal wiring that causes a potential drop after the transistor has entered an off state. According to the latter configuration, it is possible to suppress a drop in the gate potential that occurs during a reset due to the bidirectional conductivity of the transistor, thus enabling providing a photosensor that has a wide dynamic range.
Furthermore, the above-described display device can be favorably implemented as a liquid crystal display device further including a common substrate opposing the active matrix substrate, and liquid crystal sandwiched between the active matrix substrate and the common substrate, but is not limited to this.
Below is a description of more specific embodiments of the present invention with reference to the drawings.

Note that although the following embodiments show an example of a configuration in which the display device according to the present invention is implemented as a liquid crystal display device, the display device according to the present invention is not limited to a liquid crystal display device, and is applicable to an arbitrary display device that uses an active matrix substrate. It should also be noted that due to having a photosensor, the display device according to the present invention is envisioned to be used as, for example, a display device with a touch panel that performs input operations by detecting an object that has come close to the screen, or a bidirectional communication display device that is equipped with a display function and an image capture function.

Also, for the sake of convenience in the description, the drawings that are referred to below show simplifications of, among the constituent members of the embodiments of the present invention, only relevant members that are necessary for describing the present invention. Accordingly, the display device according to the present invention may include arbitrary constituent members that are not shown in the drawings that are referred to in this specification. Also, regarding the dimensions of the members in the drawings, the dimensions of the actual constituent members, the ratios of the dimensions of the members, and the like are not shown faithfully.

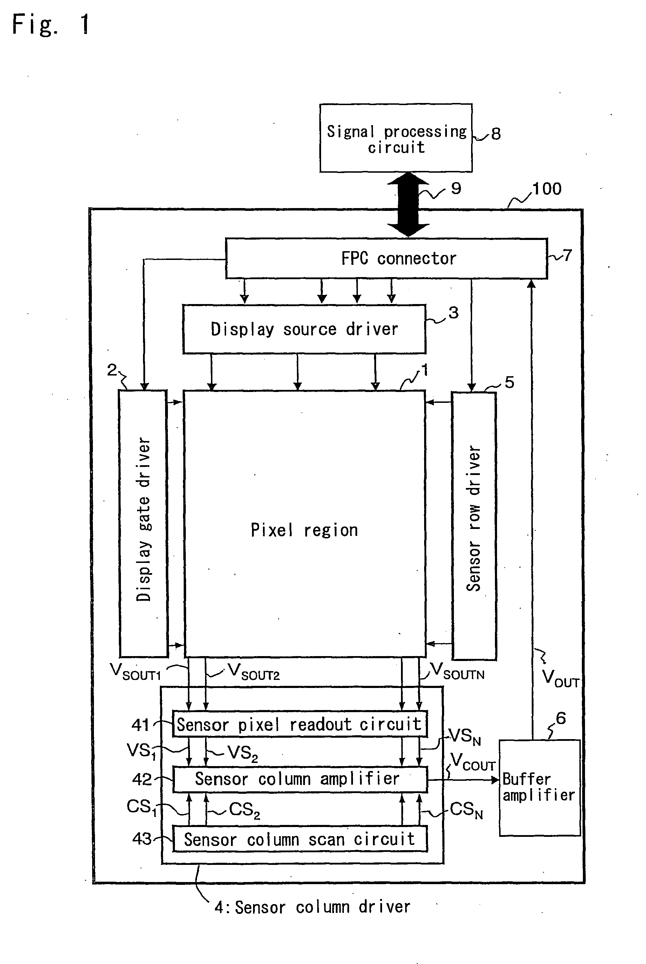

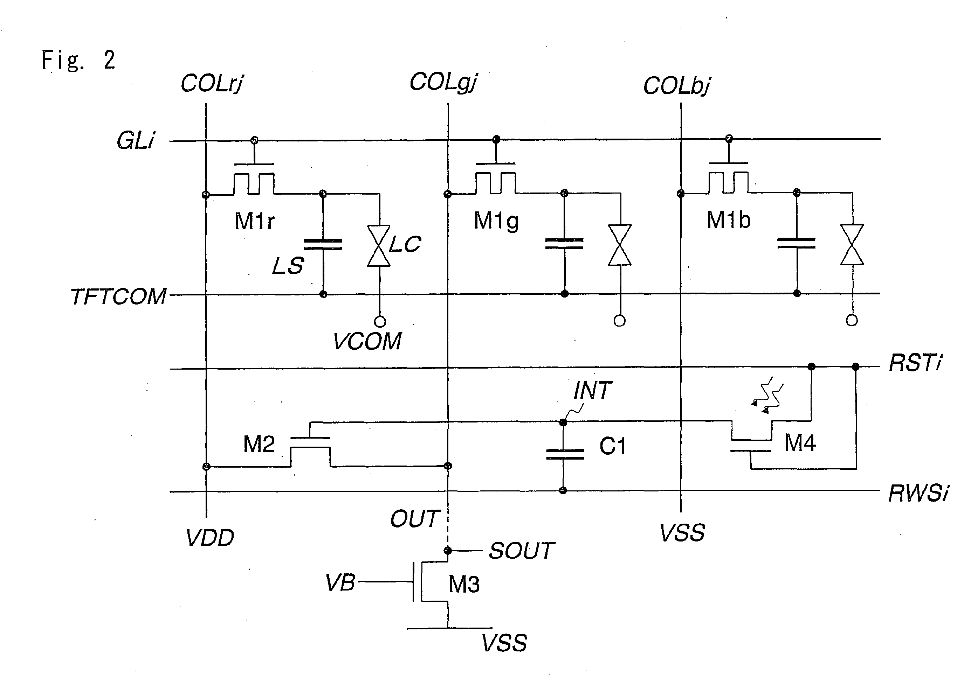

First, a configuration of an active matrix substrate included in a liquid crystal display device according to Embodiment 1 of the present invention is described with reference to FIGS. 1 and 2.

FIG. 1 is a block diagram showing a schematic configuration of an active matrix substrate 100 included in the liquid crystal display device according to Embodiment 1 of the present invention. As shown in FIG. 1, the active matrix substrate 100 includes at least a pixel region 1, a display gate driver 2, a display source driver 3, a sensor column driver 4, a sensor row driver 5, a buffer amplifier 6, and an FPC connector 7 on a glass substrate. Also, a signal processing circuit 8 for processing image signals picked up by a photodetection element (described later) in the pixel region 1 is connected to the active matrix substrate 100 via the FPC connector 7 and an FPC 9.

Note that the above constituent members on the active matrix substrate 100 can also be formed monolithically on the glass substrate by a semiconductor process. Alternatively, a configuration is possible in which the amplifier and various drivers among the above constituent members are mounted on the glass substrate by COG (Chip On Glass) technology or the like. As another alternative, it is possible for at least a portion of the above constituent members shown on the active matrix substrate 100 in FIG. 1 to be mounted on the FPC 9. The active matrix substrate 100 is attached to a common substrate (not shown) that has a common electrode formed on the entire face thereof, and a liquid crystal material is enclosed in the gap therebetween.

The pixel region 1 is a region in which a plurality of pixels are formed in order to display an image. In the present embodiment, a photosensor for picking up an image is provided in each pixel in the pixel region 1. FIG. 2 is an equivalent circuit diagram showing the disposition of the pixels and photosensors in the pixel region 1 of the active matrix substrate 100. In the example in FIG. 2, each pixel is formed by three colors of picture elements, namely R (red), G (green), and B (blue), and one photosensor configured by two photodiodes D1 and D2, a capacitor $C_{INT}$, and a thin film transistor M2 is provided in each of the pixels configured by these three picture elements. The pixel region 1 has pixels disposed in a matrix having M rows $\times$ N columns, and photosensors that are likewise disposed in a matrix having M rows $\times$ N columns. Note that as described above, the number of picture elements is Mx3N.

For this reason, as shown in FIG. 2, the pixel region 1 has, as wiring for the pixels, gate lines GL and source lines COL that are disposed in a matrix. The gate lines GL are connected to the display gate driver 2. The source lines COL are connected to the display source driver 3. Note that the gate lines GL are provided in M rows in the pixel region 1. Hereinafter, the notation GLi (i =1 to M) is used when there is a need to distinguish between individual gate lines GL in the description. Meanwhile, three of the source lines COL are provided in each pixel in order to respectively supply image data to the three picture elements in each pixel as described above. The notations COLrj, COLgj, and COLbj (j =1 to N) are used when there is a need to distinguish between individual source lines COL in the description.

Thin film transistors (TFT) M1 are provided as switching elements for the pixels at intersections between the gate lines GL and the source lines COL. Note that in FIG. 2, the thin film transistors M1 provided in the red, green, and blue picture elements are noted as M1r, M1g, and M1b respectively. In each thin film transistor M1, the gate electrode is connected to one of the gate lines GL, the source electrode is connected to one of the source lines COL, and the drain electrode is connected to a pixel electrode that is not shown. Accordingly, as shown in FIG. 2, a liquid crystal capacitor LC is formed between the drain electrode of each thin film transistor M1 and the common electrode (VCOM). Also, an auxiliary capacitor LS is formed between each drain electrode and a TFTCOM.

In FIG. 2, the picture element driven by the thin film transistor M1r, which is connected to the intersection between one gate line GLi and one source line COLrj, is provided with a red color filter so as to correspond to that picture element, and red image data is supplied from the display source driver 3 to that picture element via the source line COLrj, and thus that picture element functions as a red picture element. Also, the picture element driven by the thin film transistor M1g, which is connected to the intersection between the gate line GLi and the source line COLgj, is provided with a green color filter so as to correspond to that picture element, and green image data is supplied from the display source driver 3 to that picture element via the source line COLgj, and thus that picture element functions as a green picture element. Furthermore, the picture element driven by the thin film transistor M1b, which is connected to the intersection between the gate line GLi and the source line COLbj, is provided with a blue color filter so as to correspond to that picture element, and blue image data is supplied from the display source driver 3 to that picture element via the source line COLbj, and thus that picture element functions as a blue picture element.

In the example in FIG. 2, the source line COLr also serves as wiring VDD, which is for supplying a constant voltage $V_{DD}$ from the sensor column driver 4 to the photosensor. Also, a source line COLg also serves as wiring OUT for sensor output.

Note that in the example in FIG. 2, the photosensors are provided in the ratio of one per pixel (three picture elements) in the pixel region 1. However, the disposition ratio of the pixels and photosensors is arbitrary and not limited to merely this example. For example, one photosensor may be disposed per picture element, and a configuration is possible in which one photosensor is disposed for a plurality of pixels.

As shown in FIG. 2, the photosensor is configured by a phototransistor (photo TFT) M4 as a photodetection element, the capacitor $C_{INT}$, and the thin film transistor M2 as a sensor switching element. Note that the phototransistor M4 may have either a top-gate structure or a bottom-gate structure. In the case of the bottom-gate structure, the gate electrode functions as a light-shielding layer that blocks light from the backlight from incidenting on the phototransistor M4, which has the advantage that the manufacturing process can be simplified.

The gate and the source of the phototransistor M4 are both connected to the reset wiring RST. The phototransistor M4 is not limited to being a polysilicon TFT having a high mobility, and can be an amorphous silicon TFT or a microcrystalline silicon TFT Note that the transistor M2 can also be realized by an amorphous silicon TFT or a microcrystalline silicon TFT. Accordingly, the transistor M2 and the phototransistor M4 can be formed at the same time using the same material.

Using the phototransistor M4 as the photodetection element has the following advantages. Specifically, unlike a photodiode that requires the formation of a p layer and an n layer, with the phototransistor M4 it is sufficient to form only one semiconductor layer (e.g., an n channel). Also, the channel width, which is an important parameter that determines the characteristics of the phototransistor, is influenced by only the precision of the process for forming the semiconductor layer or the precision of the gate width. For this reason, a phototransistor has less variation in characteristics due to variations in precision in the manufacturing process, in comparison to a photodiode. This consequently enables realizing a high-quality display device with a photosensor that has little variation in characteristics between sensors.

The drain of the transistor M2 is connected to the wiring VDD, and the source is connected to the wiring OUT. The wiring RST and RWS are connected to the sensor row driver 5. Since the wiring RST and RSW are provided in each row, the notations RSTi and RWSi (i =1 to M) are used hereinafter when there is a need to distinguish between the wiring.

The sensor row driver 5 successively selects each group of wiring RSTi and RWSi shown in FIG. 2 at a predetermined time interval ($t_{row}$). Accordingly, each photosensor row in the pixel region 1 from which a signal charge is to be read is successively selected.

Note that as shown in FIG. 2, the end of the wiring OUT is connected to the drain of an insulated gate field effect transistor M3. Also, the drain of this transistor M3 is connected to output wiring SOUT, and a potential $V_{SOUT}$ of the drain of the transistor M3 is output to the sensor column driver 4 as an output signal from the photosensor. The source of the transistor M3 is connected to the wiring VSS. The gate of the transistor M3 is connected to a reference voltage power supply (not shown) via reference voltage wiring VB.

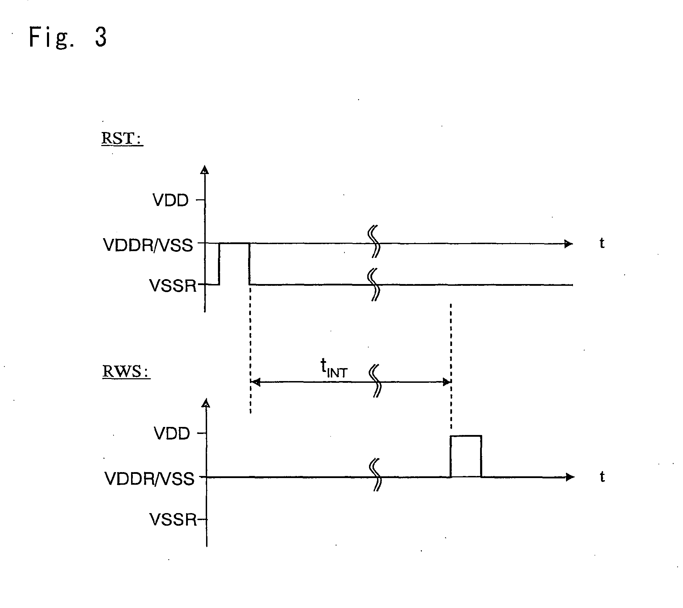

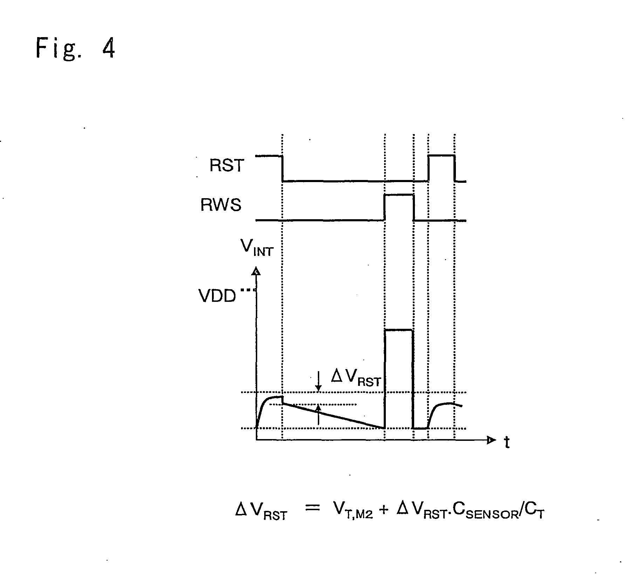

A description is now given of operations of the photosensor according to the present embodiment with reference to FIGS. 3 and 4. FIG. 3 is a timing chart showing the waveforms of the reset signal supplied from the wiring RST to the photosensor and the readout signal supplied from the wiring RWS to the photosensor. FIG. 4 is a waveform diagram showing the relationship between the input signals (RST and RWS) and $V_{INT}$ in the photosensor according to Embodiment 1.

In the example shown in FIG. 3, the high level $V_{RSTH}$ of the reset signal is equivalent to Vss. Also, the high level $V_{RWS.H}$ of the readout signal is equivalent to $V_{DD}$, and the low level $V_{RWS.L}$ thereof is equivalent to Vss.

In the photosensor according to the present embodiment, when the reset signal RST is at high level, the potential $V_{INT}$ of the gate electrode of the transistor M2 is expressed by Expression (4) below.

$$V_{INT} = V_{RST.H} - V_{T,M2} - \Delta V_{RST} \cdot C_{SENSOR}/C_T \quad \quad ...(4)$$

In Expression (4), $V_{T,M2}$ is the threshold voltage of the transistor M2, $\Delta V_{RST}$ is the height of the reset signal pulse ($V_{RST.H}$ - $V_{RST.L}$), and $C_{SENSOR}$ is the capacitance of the phototransistor M4. $C_T$ is the sum of the capacitance of the capacitor C2, the capacitance $C_{SENSOR}$ of the phototransistor M4, and a capacitance $C_{TFT}$ of the transistor M2. Since $V_{INT}$ is lower than the threshold voltage of the transistor M2 at this time, the transistor M2 is in a non-conducting state in the reset period.

Next, the reset signal returns to the low level $V_{RST \cdot L}$, and thus the photocurrent integration period begins. In the integration period, a photocurrent that is proportionate to the amount of incident light received by the phototransistor M4 flows to the capacitor C2, and causes the capacitor C2 to discharge. Accordingly, the potential $V_{INT}$ of the gate of the transistor M2 when the integration period ends is expressed by Expression (5) below.

$$V_{INT} = V_{RST.H} - V_{T,M2} - \Delta V_{RST} \cdot C_{SENSOR}/C_T$$

$$- I_{PHOTO} \cdot T_{INT}/C_T \qquad ...(5)$$

In Expression (5), $I_{PHOTO}$ is the photocurrent of the phototransistor M4, and $T_{INT}$ is the length of the integration period. In the integration period as well, $V_{INT}$ is lower than the threshold voltage of the transistor M2, and therefore the transistor M2 is in the non-conducting state.

When the integration period ends, the readout signal RWS rises, and thus the readout period begins. Note that the readout period continues while the readout signal RWS is at high level. Here, the injection of charge into the capacitor C2 occurs. As a result, the potential $V_{INT}$ of the gate of the transistor M2 is expressed by Expression (6) below.

$$V_{INT} = V_{RST.H} - V_{T,M2} - \Delta V_{RST} \cdot C_{SENSOR}/C_T - I_{PHOTO} \cdot T_{INT}/C_T$$

$$+ \Delta V_{RWS} \cdot C_{INT}/C_T \qquad ...(6)$$

$\Delta V_{RWS}$ is the height of the readout signal pulse ($V_{RWS.H}$ - $V_{RWS.L}$). Accordingly, since the potential $V_{INT}$ of the gate of the transistor M2 becomes higher than the threshold voltage, the transistor M2 enters the conducting state and functions as a source follower amplifier along with a bias transistor M3 provided at the end of the wiring OUT in each column. In other words, a sensor output voltage $V_{PIX}$ from the transistor M2 is proportionate to the integral value of the photocurrent of the phototransistor M4 in the integration period.

As described above, periodically performing initialization with a reset pulse, integrating the photocurrent in the integration period, and reading out sensor output in the readout period enables obtaining photosensor output for each pixel.

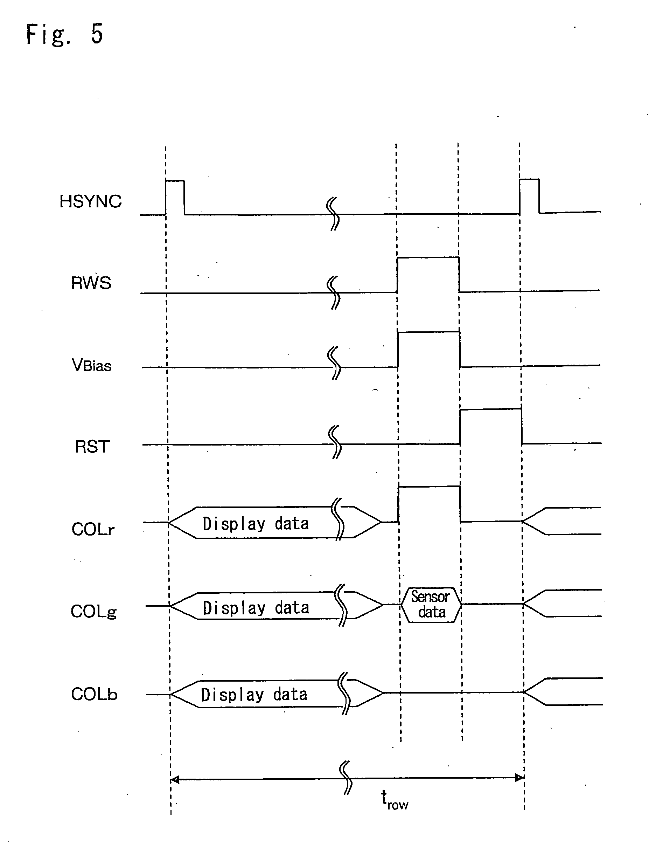

In the present embodiment, as previously described, the source lines COLr, COLg, and COLb are also used as the photosensor wiring VDD and OUT, and therefore as shown in FIG. 5, it is necessary to distinguish between times when image data signals for display are input via the source lines COLr, COLg, and COLb, and times when sensor output is read via the source lines COLr, COLg, and COLb. In the example in FIG. 5, after the input of the image data signal for display in a horizontal scan period has ended, the reading out of sensor output is performed using a horizontal blanking period or the like.

As shown in FIG. 1, the sensor column driver 4 includes a sensor pixel readout circuit 41, a sensor column amplifier 42, and a sensor column scan circuit 43. The sensor pixel readout circuit 41 is connected to the wiring SOUT (see FIG. 2) that outputs the sensor output $V_{SOUT}$ from the pixel region 1. In FIG. 1, the sensor output that is output by wiring SOUTj (j =1 to N) is noted as $V_{SOUTj}$. The sensor pixel readout circuit 41 outputs peak hold voltages $V_{Sj}$ of the sensor output $V_{SOUTj}$ to the sensor column amplifier 42. The sensor column amplifier 42 includes an N number of column amplifiers that respectively correspond to the photosensors in the N columns in the pixel region 1, and the column amplifiers respectively amplify the peak hold voltages $V_{Sj}$ (j = 1 to N), and output the resulting peak hold voltages to the buffer amplifier 6 as $V_{COUT}$. The sensor column scan circuit 43 outputs column select signals CSj (j =1 to N) to the sensor column amplifier 42 in order to successively connect the column amplifiers of the sensor column amplifier 42 to the output bound for the buffer amplifier 6.

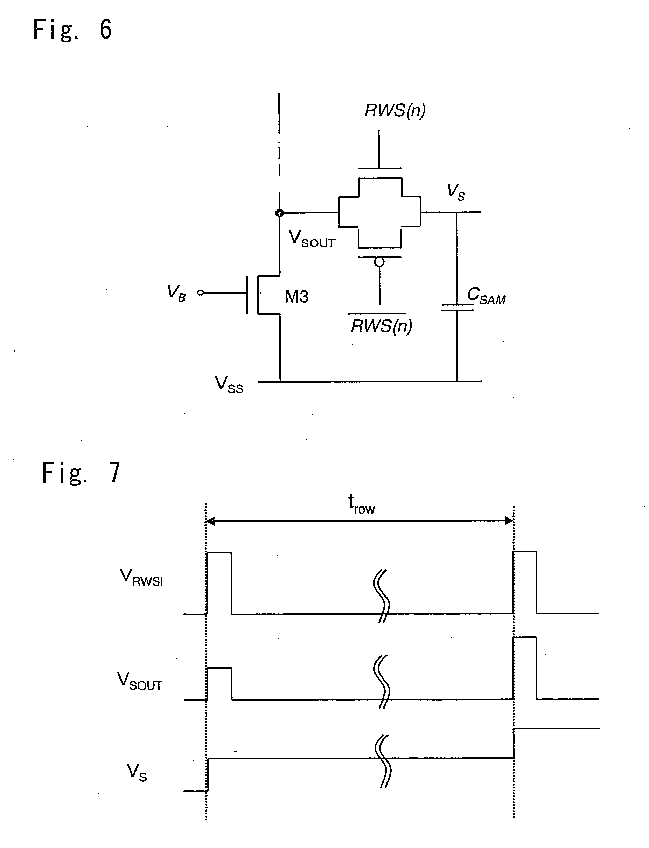

The following describes operations of the sensor column driver 4 and the buffer amplifier 6 that are performed after the sensor output $V_{SOUT}$ has been read out from the pixel region 1, with reference to FIGS. 6 and 7. FIG. 6 is a circuit diagram showing an internal configuration of the sensor pixel readout circuit 41. FIG. 7 is a waveform diagram showing a relationship between the readout signal $V_{RWS}$, the sensor output $V_{SOUT}$, and the output Vs of the sensor pixel readout circuit. As previously described, when the readout signal has risen to the high level $V_{RWS.H}$, the transistor M2 becomes conductive, and therefore a source follower amplifier is formed by the transistors M2 and M3, and the sensor output $V_{SOUT}$ is accumulated in a sample capacitor $C_{SAM}$ of the sensor pixel readout circuit 41. Accordingly, even after the readout signal has fallen to the low level $V_{RWS.L}$, in the selection period of that row ($t_{row}$), the output voltage Vs from the sensor pixel readout circuit 41 to the sensor column amplifier 42 is kept at the same level as the peak value of the sensor output $V_{SOUT}$, as shown in FIG. 7.

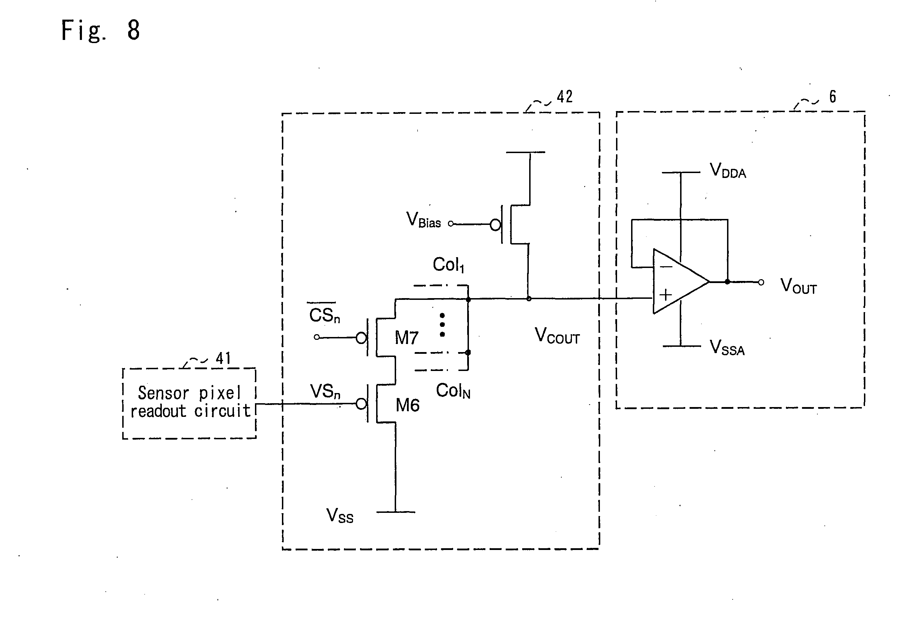

Next is a description of operations of the sensor column amplifier 42 with reference to FIG. 8. As shown in FIG. 8, the output voltages $V_{Sj}$ (j =1 to N) of the columns are input from the sensor pixel readout circuit 41 to the N number of column amplifiers of the sensor column amplifier 42. As shown in FIG. 8, each column amplifier is configured by transistors M6 and M7. The column select signals $C_{Sj}$ generated by the sensor column scan circuit 43 successively become ON for each of the N columns in the select period of one row ($t_{row}$), and therefore the transistor M6 of only one of the N number of column amplifiers in the sensor column amplifier 42 is switched on, and only any one of the output voltages $V_{Sj}$ (j = 1 to N) of the columns is output as the output $V_{COUT}$ from the sensor column amplifier 42 via that transistor M6. The buffer amplifier 6 then amplifies the $V_{COUT}$ that has been output from the sensor column amplifier 42, and outputs the resulting amplified $V_{COU}T$ to the signal processing circuit 8 as panel output (a photosensor signal) $V_{out}$.

Note that although the sensor column scan circuit 43 may scan the photosensor columns one column at a time as described above, there is no limitation to this, and a configuration is possible in which the photosensor columns are interlace-scanned. Also, the sensor column scan circuit 43 may be formed as a multi-phase drive scan circuit that has, for example, four phases.

According to the above configuration, the display device according to the present embodiment obtains panel output $V_{OUT}$ that is in accordance with the amount of light received by the phototransistor M4 formed in each pixel in the pixel region 1. The panel output $V_{OUT}$ is sent to the signal processing circuit 8, has A/D conversion performed thereon, and is accumulated in a memory (not shown) as panel output data. Specifically, the same number of panel output data pieces as the number of pixels (number of photosensors) in the pixel region 1 are accumulated in this memory. With use of the panel output data accumulated in the memory, the signal processing circuit 8 performs various types of signal processing such as image pickup and the detection of a touch area. Note that although the same number of panel output data pieces as the number of pixels (number of photosensors) in the pixel region 1 are accumulated in the memory of the signal processing circuit 8 in the present embodiment, due to constraints such as memory capacity, there is no need to necessarily accumulate the same number of panel output data pieces as the number of pixels.

As described above, the display device according to the present embodiment enables obtaining photosensor output even when the phototransistor M4 is used in place of a conventional photodiode as the photodetection element of a photosensor. Also, in particular, forming the transistor M2 and the phototransistor M4 from an amorphous silicon TFT or a microcrystalline silicon TFT has the advantage of enabling more inexpensive manufacturing than when using polysilicon.

Embodiment 2

Below is a description of a display device according to Embodiment 2 of the present invention. Note that the same reference numerals have been used for constituent elements that have functions likewise to those of the constituent elements described in Embodiment 1, and detailed descriptions thereof have been omitted.

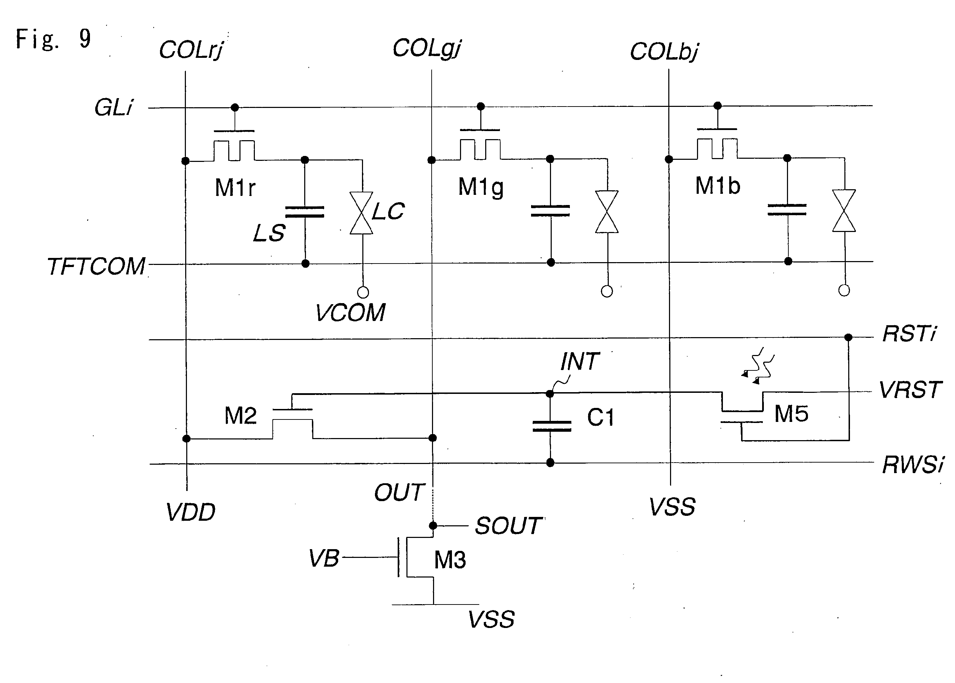

As shown in FIG. 9, a display device according to Embodiment 2 differs from Embodiment 1 in that a phototransistor M5 is included as the photodetection element of the photosensor in place of the phototransistor M4 described in Embodiment 1. The phototransistor M5 is the same as the phototransistor M4 in that the gate is connected to the reset wiring RST, and differs from the phototransistor M4 in that the source is connected to wiring for supplying a second reset signal VRST that is different from the reset signal RST.

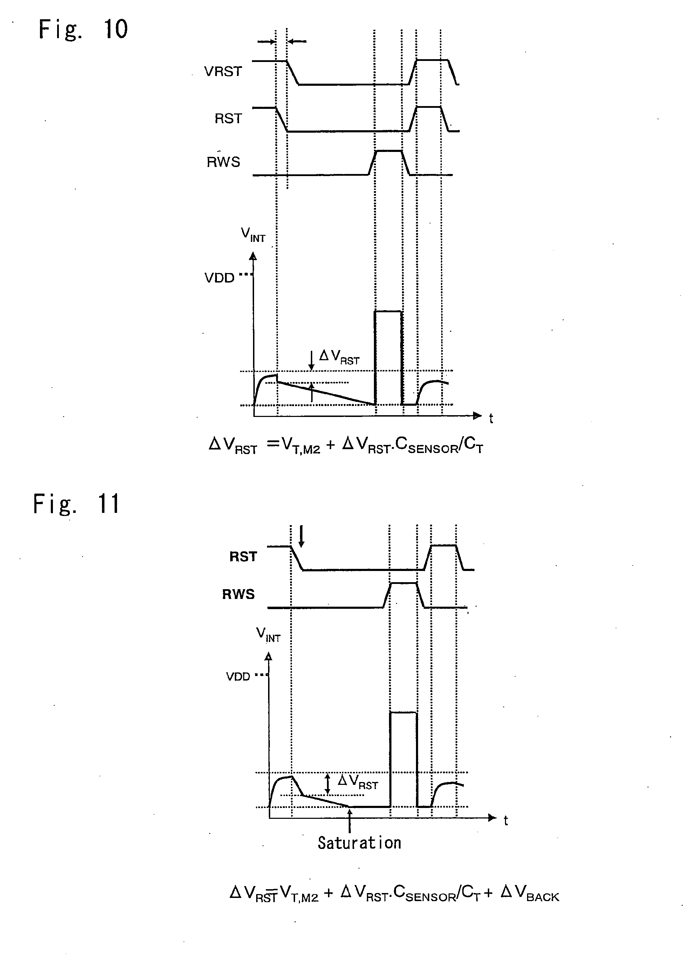

The following describes operations of the photosensor according to the present embodiment with reference to FIGS. 10 and 11. FIG. 10 is a waveform diagram showing the relationship between $V_{INT}$ and various signals that are applied to the photosensor according to the present embodiment. FIG. 11 is a waveform diagram showing, as a comparative example, change in $V_{INT}$ in the case where the drop in the potential of the reset signal RST was not steep in the configuration according to Embodiment 1.

As shown in FIG. 11, in the case where the drop in the potential of the reset signal RST in the configuration according to Embodiment 1 was not steep, the potential $V_{INT}$ of the gate electrode of the transistor M2 falls a substantial amount ($\Delta V_{BACK}$ shown in FIG. 11) in the potential drop period of the reset signal RST. This reason for this is that the phototransistor M4 has bidirectional conductivity, unlike a photodiode. In this case, the dynamic range of the pixel is reduced by an amount commensurate to the drop $\Delta V_{BACK}$, thus causing the problem of saturation by a small amount of light.

In the configuration according to the present embodiment, in order to address this problem, separate reset signals RST and VRST are respectively applied to the gate and source of the phototransistor M5 as described above. As shown in FIG. 10, the drop in the potential of the second reset signal VRST applied to the source of the phototransistor M5 begins once the reset signal RST is completely at low level, that is to say, once the phototransistor M5 has switched to the off state. Accordingly, as shown by a comparison of FIGS. 10 and 11, the drop in the potential $V_{INT}$ ($\Delta V_{BACK}$) seen in FIG. 11 does not occur in the configuration of the present embodiment shown in FIG. 10, thus enabling realizing a photosensor having a wide dynamic range.

Although the present invention has been described based on Embodiments 1 and 2, the present invention is not limited to only the above-described embodiments, and it is possible to make various changes within the scope of the invention.

For example, in the exemplary configurations given in Embodiments 1 and 2, the wiring VDD and OUT connected to the photosensor are also used as source wiring SL. This configuration has the advantage that the pixel aperture ratio is high. However, a configuration is possible in which the wiring VDD and OUT for the photosensor is provided separately from the source wiring SL.

Industrial Applicability

The present invention is industrially applicable as a display device having a photosensor in a pixel region of an active matrix substrate.

Reference Signs List

| | |
|---|---|
| 1 | pixel region |
| 2 | display gate driver |
| 3 | display source driver |
| 4 | sensor column driver |
| 41 | sensor pixel readout circuit |
| 42 | sensor column amplifier |
| 43 | sensor column scan circuit |
| 5 | sensor row driver |
| 6 | buffer amplifier |
| 7 | FPC connector |
| 8 | signal processing circuit |
| 9 | FPC |
| 100 | active matrix substrate |
| M2 | thin film transistor (sensor switching element) |
| M4 | phototransistor (photodetection element) |

**Claims**

1. A display device comprising a photosensor in a pixel region of an active matrix substrate,
   the photosensor comprising:

   a photodetection element that receives incident light;
   a capacitor, one electrode of which is connected to the photodetection element, that accumulates output current from the photodetection element;
   reset signal wiring that supplies a reset signal to the photosensor;
   readout signal wiring that supplies a readout signal to the photosensor; and
   a sensor switching element that, in accordance with the readout signal, reads out the output current accumulated in the capacitor from when the reset signal is supplied until when the readout signal is supplied,
   wherein the photodetection element is a phototransistor.

2. The display device according to claim 1, wherein the photodetection element is an amorphous silicon TFT or a microcrystalline silicon TFT.

3. The display device according to claim 1 or 2, wherein the sensor switching element is an amorphous silicon TFT or a microcrystalline silicon TFT.

4. The display device according to any one of claims 1 to 3, wherein a gate and a source of the phototransistor are connected to the reset signal wiring.

5. The display device according to any one of claims 1 to 3, wherein the reset signal wiring is connected to a gate of the phototransistor, and second reset signal wiring that causes a potential drop after the phototransistor has entered an off state is connected to a source of the phototransistor.

6. The display device according to any one of claims 1 to 5, further comprising:

a common substrate opposing the active matrix substrate; and
liquid crystal sandwiched between the active matrix substrate and the common substrate.

# Fig. 1

Signal processing circuit ~8

~9    ~100

FPC connector ~7

Display source driver ~3

2~    ~1    ~5

Display gate driver

Pixel region

Sensor row driver

$V_{SOUT1}$    $V_{SOUT2}$    $V_{SOUTN}$    $V_{OUT}$

41 — Sensor pixel readout circuit    $VS_N$

$VS_1$    $VS_2$    $V_{COUT}$    6

42 — Sensor column amplifier    Buffer amplifier

$CS_1$    $CS_2$    $CS_N$

43 — Sensor column scan circuit

4: Sensor column driver

Fig. 2

EP 2 287 657 A1

# Fig. 3

RST:

VDD

VDDR/VSS

VSSR

t

$t_{INT}$

RWS:

VDD

VDDR/VSS

VSSR

t

# Fig. 4

$$\Delta V_{RST} = V_{T,M2} + \Delta V_{RST} \cdot C_{SENSOR}/C_T$$

Fig. 5

Fig. 6

Fig. 7

Fig. 8

Fig. 9

EP 2 287 657 A1

Fig. 10

$$\Delta V_{RST} = V_{T,M2} + \Delta V_{RST} \cdot C_{SENSOR}/C_T$$

Fig. 11

Saturation

$$\Delta V_{RST} = V_{T,M2} + \Delta V_{RST} \cdot C_{SENSOR}/C_T + \Delta V_{BACK}$$

19

Fig. 12

Fig. 13

## INTERNATIONAL SEARCH REPORT

| International application No. |
| --- |
| PCT/JP2009/059769 |

### A. CLASSIFICATION OF SUBJECT MATTER
*G02F1/133*(2006.01)i, *G02F1/1335*(2006.01)i, *G02F1/1368*(2006.01)i, *G09F9/30* (2006.01)i, *H01L31/10*(2006.01)i

According to International Patent Classification (IPC) or to both national classification and IPC

### B. FIELDS SEARCHED

Minimum documentation searched (classification system followed by classification symbols)
G02F1/133, G02F1/1335, G02F1/1368, G09F9/30, H01L31/10

Documentation searched other than minimum documentation to the extent that such documents are included in the fields searched
Jitsuyo Shinan Koho        1922-1996   Jitsuyo Shinan Toroku Koho   1996-2009
Kokai Jitsuyo Shinan Koho   1971-2009   Toroku Jitsuyo Shinan Koho   1994-2009

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
| --- | --- | --- |
| X<br>Y<br>A | JP 2007-304245 A  (Sony Corp.),<br>22 November, 2007 (22.11.07),<br>Par. Nos. [0022] to [0057]; Fig. 3<br>(Family: none) | 1,6<br>2,3<br>4,5 |
| X<br>A | JP 2006-79589 A  (Sanyo Electric Co., Ltd.),<br>23 March, 2006 (23.03.06),<br>Par. Nos. [0047] to [0054], [0203] to [0216]<br>& US 2006/0033016 A1    & KR 10-2006-0049286 A<br>& CN 1758197 A | 1,4<br>2,3,5,6 |
| Y<br>A | JP 6-11690 A  (Rohm Co., Ltd.),<br>21 January, 1994 (21.01.94),<br>Par. Nos. [0006] to [0012]; Fig. 2<br>(Family: none) | 2,3<br>1,4-6 |

☐ Further documents are listed in the continuation of Box C.      ☐ See patent family annex.

| * Special categories of cited documents: | "T" later document published after the international filing date or priority date and not in conflict with the application but cited to understand the principle or theory underlying the invention |
| --- | --- |
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search<br>17 June, 2009 (17.06.09) | Date of mailing of the international search report<br>30 June, 2009 (30.06.09) |
| --- | --- |
| Name and mailing address of the ISA/<br>Japanese Patent Office | Authorized officer |
| Facsimile No. | Telephone No. |

Form PCT/ISA/210 (second sheet) (April 2007)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2006003857 A
- WO 2007145346 A
- WO 2007145347 A